Europäisches Patentamt

European Patent Office

Office européen des brevets

(19)

(11) Publication number: **0 123 384**

**A1**

(12) # EUROPEAN PATENT APPLICATION

(21) Application number: **84301151.1**

(22) Date of filing: **22.02.84**

(51) Int. Cl.³: **H 01 L 21/82**
**H 01 L 27/08**

(30) Priority: **25.02.83 US 469587**

(43) Date of publication of application:
**31.10.84 Bulletin 84/44**

(84) Designated Contracting States:
**AT DE GB IT NL**

(71) Applicant: **Western Digital Corporation**
**2445 McCabe Way**
**Irvine California 92714(US)**

(72) Inventor: **Harper, Francis E.**
**1101 West MacArthur, No. 215**
**Santa Ana California 92707(US)**

(74) Representative: **Hallam, Arnold Vincent et al,**
**E.N. LEWIS & TAYLOR 144 New Walk**
**Leicester LE1 7JA(GB)**

(54) **Complementary insulated gate field effect integrated circuit structure and process for fabricating the structure.**

(57) A CMOS isoplanar silicon gate integrated circuit structure and a process for fabricating such structure wherein the field associated with the P channel devices and the field associated with N channel devices are separately patterned and implanted using two photoresist nitride etch and implant masks to separately determine the characteristics of each field. The process for making such CMOS integrated circuit includes split field masking steps. An alternate embodiment employs a guard ring around P-wells with a relatively thick oxide thereover to enable low capacitance polysilicon crossovers to be formed over said guard ring. The CMOS integrated circuit structure further includes a self-aligned silicon gate, with the gate electrode.

EP 0 123 384 A1

Croydon Printing Company Ltd.

./...

BORON

FIG. 6

PHOTORESIST
SILICON NITRIDE
SILICON OXIDE
SILICON

P-WELL

38  24  22  38  28  27  26  30  32

FIG. 16

51  69  51  51

22  53  27  10

COMPLIMENTARY INSULATED GATE FIELD EFFECT
INTEGRATED CIRCUIT STRUCTURE AND PROCESS FOR
FABRICATING THE STRUCTURE

The invention relates to the field of MOS devices, CMOS devices and processes and fabrication techniques therefor.

Complimentary metal-oxide-semiconductor (CMOS) devices and integrated circuits employing an N Channel and P Channel field effect devices are well known in the art. These devices are often employed in applications requiring low power consumption and high noise immunity over a wide range of power supply voltages. Such devices were early disclosed in U.S. Patent 3,356,858 issued to Wanlass.

Integrated circuits employing MOS devices commonly require power supply voltages of approximately 1.0 to 40 volts or more. To enable such operation the inversion voltage for parasitic transistors between such devices must be increased substantially above the supply voltage. In MOS integrated circuit devices employing either P channel devices, N channel devices or both one method of achieving higher field threshholds is by increasing the thickness of the field oxide thus result in increasing the size of silicon dioxide steps and causing larger final integrated chip size due to patterning limitations and other related problems. A second method of increasing the field threshold voltages is by increasing the P type or N type background doping levels in the wafer which tends to degrade device performance. The problems employing these techniques are further accentuated and result in other difficulties where high density integrated circuits are involved employing CMOS silicon gate devices as here both PMOS and NMOS elements must be made and process procedures which assist in creating one element properly are harmful or ineffective in creating the other element properly.

With respect to CMOS integrated circuits certain prior art has employed channel stops and guard rings and other techniques to attempt to solve such problems. Such prior art patents are U.S. Patent 4,013,484, U.S. Patent 4,223,334, and U.S. Patent 3,983,620. For the purposes of this specification a guard ring is defined as a annular ring in the semiconductor substrate which ring surrounds a P-well region in the semiconductor substrate containing one or more active NMOS devices and which ring has a substantially higher concentration of like impurities than the surrounded P-well. A channel stop is defined as a diffused region of one conductivity type (N or P) placed between but separated from two diffusions of opposite conductivity type (P or N) for the purpose of raising the inversion voltage (channel stopping) in the channel between the two diffusions. A field implant is defined as a general increase of the P or N type background doping levels, in the surface region and specifically in all areas of the substrate not designated as the areas wherein the active devices are intended to be formed. The development of isoplanar processes and the use of field implants is suggested by such prior art as U.S. Patent 3,752,711 and "MOS Field Threshold Increase By Phosphorus Implanted Field" by Sansbury IEEE Trans Elec. Dev. ED 20 473 (1973).

With respect to field implant technology for CMOS isoplanar devices, the prior art processes have included the implanting of only one field which results in certain performance limitations. There have also been attempts to use one sheet implant and one field implant which result in certain limitations in impurity concentration profiles that are possible. This limits the magnitude of the field inversion voltage that can be attained or compromises other device characteristics (i.e., capacitance and body effect). The use of two field implants has been employed wherein a silicon nitride layer is employed as a mask to accomplish one of the field implants. With respect to the use of a thin silicon nitride layer (e.g. 800 - 1000Å) to form one of the field implant masks, it has been found that such silicon nitride layer is not as effective a mask as photoresist of an appropriate thickness. If a thick silicon nitride layer (e.g. 1500 - 2000Å) is employed both as a field implant mask and in later isoplanar process steps not only is there a certain loss in dimensional control but defects are introduced and yield loss is possible if not probable. There are no such problems encountered when employing photoresist which generally forms a thicker layer (e.g. 8000Å) and notwithstanding such thickness provides the required dimensional control.

In certain circumstances the use of a field implant which generally increases the field inversion voltage characteristic of the overall integrated circuit is employed and guard rings may also be required or desirable. On the other hand, in CMOS integrated circuits where polysilicon cross-overs are employed passing over the P-well boundary, particular problems have existed which make use of guard rings and such polysilicon cross-overs difficult and impractical.

In PMOS silicon gate devices which form an integrated circuit and specifically part of a CMOS integrated circuit there has been a practice of employing boron as one of the P-type impurities for forming the source and drain regions. The use of boron as the conductivity creating impurity can result in such impurity entering the silicon gate electrode which causes threshhold instability especially when thin gate oxides are employed. It has been suggested that a silicon nitride layer may be employed over the silicon gate electrode to keep boron from entering the silicon gate electrode and subsequently into the gate oxide itself. This method, while tending to prevent boron from entering the top surface of the silicon gate, will not prevent boron from entering the sidewall of the gate electrode if a thermal deposition is employed as a source of boron, and is consequently unsatisfactory for short channel PMOS devices. If ion implantation is used as the source of boron, then a relatively thick nitride layer is required to prevent boron from entering the gate electrode and its subsequent removal is difficult or impractical.

The CMOS integrated circuit of the present invention comprises an isoplanar, self-aligned silicon gate with fully self-aligned field implants, with such field implants being associated with both the PMOS devices and the NMOS devices and having a guard ring around the P-well perimeter and the silicon gate electrode free of boron. The process for making such CMOS integrated circuits includes the use of a split field mask after forming the N and P active regions. The split field masking allows both P and N active regions to be formed with self aligned field implants. These field implants are accomplished by separately employing an N field mask step with N field nitride etch and self aligned implant process step, a P field mask step with P field nitride etch and self aligned implant step. This process enables the use of photoresist or other photosensitive masking materials in the split field masking as both a nitride etch mask and an implant mask in which case the two are self aligned.

A guard ring may be added to surround each P-well of the integrated circuit by overlapping the field masks during the split field masking process steps to provide a guard ring region. During the subsequent field oxidation, such field oxidation is interrupted so that there is a first field oxidation followed by a guard ring masking step, a nitride etch and a guard ring implant. Thereafter, the field oxidation is completed.

A boron-free silicon gate is employed which gate is formed by employing phosphorous or other types of conductivity impurities for the gate and totally protecting the gate from boron impurities with a self aligned photoresist layer that is first used to pattern the silicon gate and is then retained during the process steps wherein the source and drain for the PMOS elements are formed by implanting boron.

In the drawings, which are described by way of example:-

FIGURE 1 is a cross-sectional, elevation view of a portion of a silicon substrate and includes an oxide layer on the upper surface of the substrate and a patterned layer of photoresist on the oxide layer.

FIGURE 2 illustrates the substrate of FIGURE 1 after the original thick oxide has been etched, the photoresist removed and a second thin oxide has been formed with a boron P-well implant step in process.

FIGURE 3 illustrates the substrate of FIGURE 2 after the P-well drive-in process step.

FIGURE 4 illustrates the substrate of FIGURE 3 after all oxide layers have been stripped and with a newly formed thin layer of oxide formed thereon with a layer of silicon nitride on the oxide layer.

FIGURE 5 illustrates the substrate of FIGURE 4 with a layer of patterned photoresist formed on the silicon nitride to form a mask enabling the field associated with the P-well and NMOS devices therein to be formed.

FIGURE 6 illustrates the substrate of FIGURE 5 with the silicon nitride removed in the areas where the self aligned field implant in connection with the P-well and NMOS devices is to take place and with the implant in process.

FIGURE 7 illustrates the substrate of FIGURE 6 after completion of the field implant associated with the P-well and NMOS devices, after forming the composite oxide and with a mask formed thereon to form the field associated with the PMOS devices. The photoresist mask is shown properly aligned (solid) and misaligned (dashed).

FIGURE 8 illustrates the substrate of FIGURE 7 with the silicon nitride removed in the areas where the field implant in connection with the PMOS devices is to take place and with the implant of the field associated with the PMOS devices taking place.

FIGURE 9 illustrates the substrate of FIGURE 8 after both fields have been implanted and with the silicon nitride retained over portions of the oxide where field oxide formation is to be prevented during subsequent processing steps.

FIGURE 10 illustrates the substrate of FIGURE 9 after the field oxidation has taken place.

FIGURE 11 illustrates the substrate of FIGURE 10 after removal of the silicon nitride and after formation of a layer of oxide to be employed as a gate oxide.

FIGURE 12(a) illustrates the substrate of FIGURE 11 prior to the formation of the source and drain region PMOS devices and after formation of the polysilicon gates and interconnects.

FIGURE 12(b) illustrates the substrate of FIGURE 12(a) after the metal interconnect layer has been formed and prior to forming the scratch protection layer.

FIGURES 13 through 17 illustrate the substrate of FIGURES 6, 7 and 9 in accordance with an alternate embodiment of the process showing masking changes and changes in forming the field oxidation necessary to form a guard ring.

It should be understood that the FIGURES illustrate only a small part of an integrated circuit with the part illustrated being repeated many times throughout the integrated circuit. The FIGURES are intended only to be schematic in nature and are not intended to be precise in dimensions, configurations or relative sizes.

The process for making a CMOS integrated circuit employing the subject invention can be understood by persons of skill in the art by reference to the various process steps employed which individually are well-known in the art. The process steps employed in forming isoplanar silicon gate devices are disclosed in U.S. Patent 3,913,211. The process steps employed in forming devices utilizing isoplanar oxide isolation are described in U.S. Patents 3,648,125, 3,752,711, and 3,913,211. The process steps employed in connection with ion implantation are descrbied in U.S. Patent 3,912,545 (Re 29,660). The process steps employed to form CMOS integrated circuit devices are described in U.S. Patent 4,027,380 and 4,135,955. With a background of such well-known integrated circuit and CMOS technology, the following exemplary, Summary Process Flow Chart, listing the process steps to make a CMOS integrated device in accordance with the subject invention, can be readily understood.

## SUMMARY PROCESS FLOW CHART
### (Without Guard Ring)

| Process Step # | Process Steps |
| --- | --- |
| 1. | Initial oxidation. |
| 2. | P-well mask. |
| 3. | Pre-implant oxidation. |
| 4. | P-well implant. |
| 5. | P-well diffusion. |
| 6. | Oxide strip. |
| 7. | Pre-nitride oxidation. |
| 8. | Nitride deposition. |
| 9. | NMOS field mask. |
| 10. | N field nitride etch |
| 11. | NMOS field implant. |

| Process Step # | Process Steps |
|---|---|
| 12. | Resist strip/clean. |
| 13. | N field drive-in. |
| 14. | Composite oxidation. |
| 15. | PMOS field mask. |
| 16. | PMOS field nitride etch. |
| 17. | PMOS field implant. |
| 18. | Resist strip/clean. |
| 19. | Field oxidation. |
| 20. | Nitride strip pre-nitride oxide strip and clean. |
| 21. | Gate oxidation. |
| 22. | P threshold adjust mask. |
| 23. | P threshold adjust implant. |
| 24. | Resist strip/clean. |
| 25. | N threshold adjust mask. |
| 26. | N threshold adjust implant. |
| 27. | Resist strip/clean. |
| 28. | Polysilicon deposition. |
| 29. | Phosphorous deposition/oxidation. |
| 30. | Polysilicon mask. |
| 31. | PMOS ion implant mask. |
| 32. | Boron implant. |
| 33. | Resist strip clean. |
| 34. | NMOS diffusion mask. |
| 35. | Phosphorous deposition. |
| 36. | Processes for forming interconnect oxide isolation, contacts and metal interconnection. |
| 37. | Processes for mechanical device protection and backside contact. |

The foregoing Summary Flow Chart Process comprises a first embodiment of the subject invention. It should be understood that each of the above referred to process steps includes a number of detail process steps and that such steps are generally well-recognized and known in the art. For example, a masking step such as a P-well mask step refers to a well-known sequence of applying a uniform layer of photoresist polymer selectively exposing the photoresist by radiation of appropriate wavelength, developing the photoresist to leave a desired pattern, and performing an active step such as removing a layer of silicon oxide, polysilicon, metal, or silicon nitride, then removing the photoresist polymer either before or after a further active step is performed such as an ion implant step. The actual point at which the photoresist polymer is removed is in part determined by the other associated process steps. With respect to the parts of the above Summary Process Flow Chart that are particularly important with respect to the subject invention, the Summary has been made more specific but not withstanding such specificity a person of skill in the art could from the Chart steps readily ascertain a number of specific process to practice the subject invention.

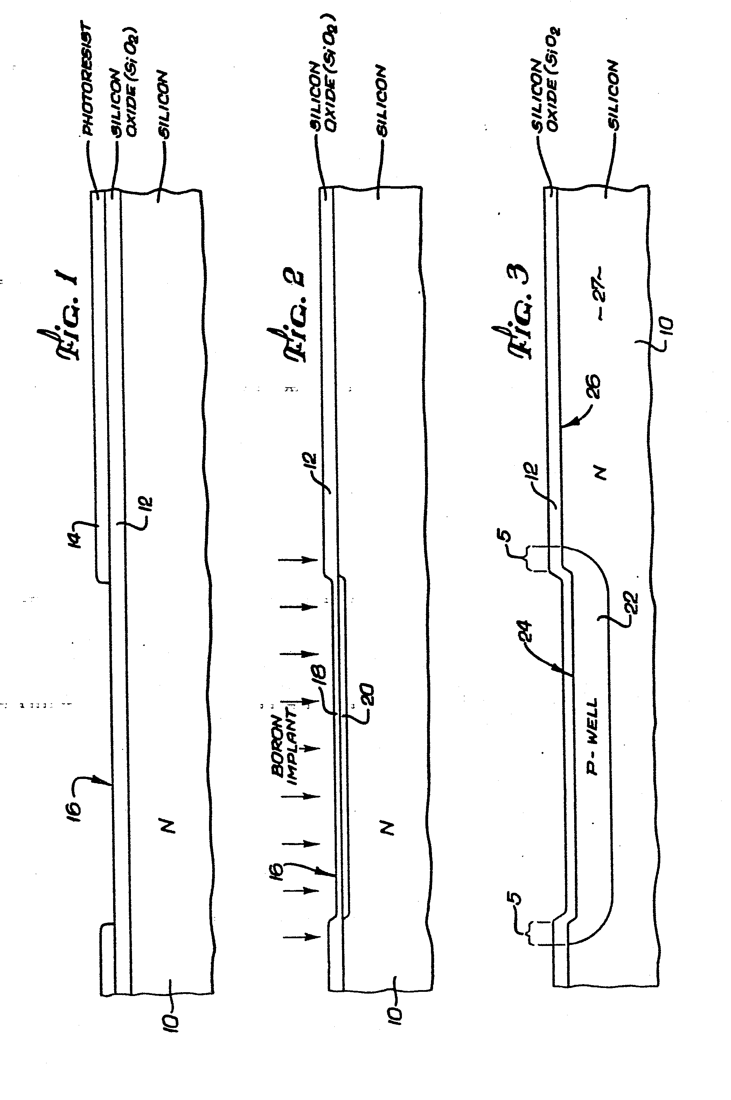

The above Summary Process Flow Chart Summary and the subject invention can be further understood by reference to the figures. Referring to Figure 1, the substrate 10 is shown which in the illustrated embodiment comprises N-conductivity-type (e.g., phosphorous) monocrystaline silicon of the 100 crystal orientation. With an N-conductivity-type substrate one or many P-wells may be employed to fabricate the CMOS devices. The use of an N-conductivity-type silicon with a P-well is shown but it should be understood that it is within the scope of the subject invention to employ a P substrate and an associated N-well with the appropriate substitution of analogous process steps.

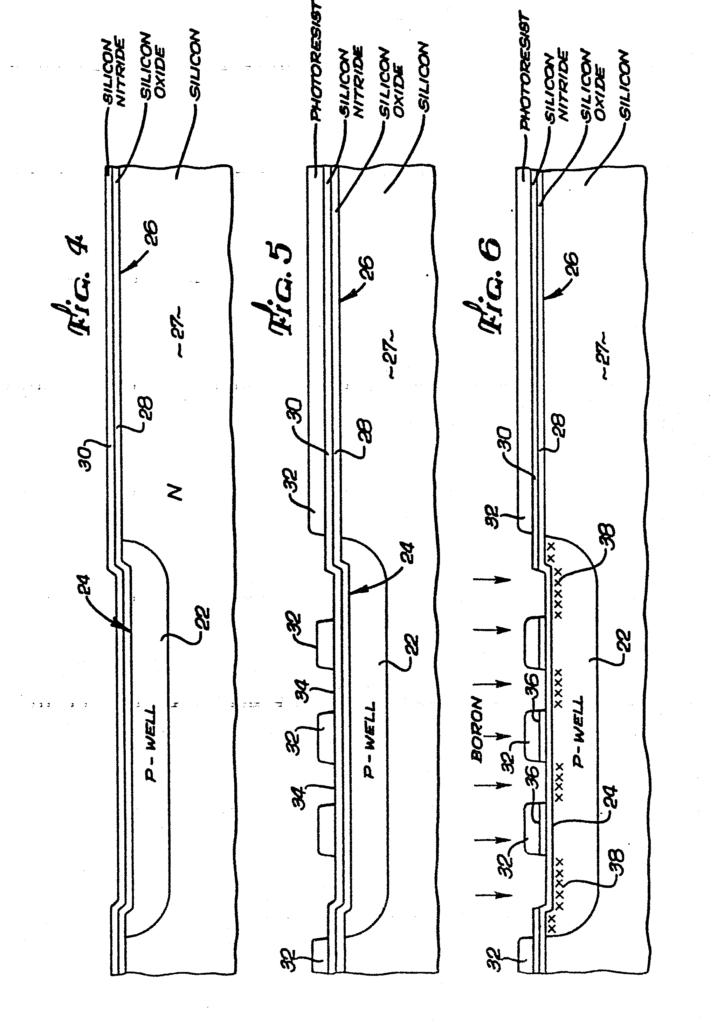

The formation of the P-well in the substrate 10 is shown in Figures 1 - 3. It should be understood that it is contemplated that many NMOS devices would be formed in a typical P-well. As shown in Figure 1, a layer of silicon oxide 12 is formed on the surface of substrate 10. The oxide layer 12 is typically 5000-6000 angstroms thick and serves to mask regions of the substrate other than that region wherein the P-well is to be formed. On top of layer 12 a patterned layer of photoresist 14 is formed which comprises the P-well mask that is employed to enable the removal of selected portions of oxide layer 12 (Step #2). With the P-well mask 14 formed a suitable etchant is applied to remove the exposed portions 16 of oxide layer 12. The exposed portions 16 of oxide layer 12 overlie the region of substrate 10 wherein the P-well is to be formed. The etchant removes all of the exposed portion of the oxide layer so that the surface of the silicon substrate 10 is exposed. Subsequent to the removal of portion 16 of the oxide layer 12, a pre-implant oxidation step (Step #3) is performed wherein approximately 600 to 1000 angstroms of oxide is regrown to assist in control of the implant and protection of the P-well to be formed by the subsequent P-well implant step (Step #4) and diffusion (Step #5). The substrate after such pre-implant oxidation step and as the P-well implant step is taking place is illustrated in Figure 2.

The P-well is formed by ion implantation of a P-type impurity. Boron is implanted beneath the thin oxide layer 18 to form ion implanted region 20. The energy level for this ion implantation is high enough for the impurity to penetrate through the thin silicon oxide layer 18 while the energy level is maintained low enough so that the impurity does not penetrate through the thick oxide 12. Thus, only region 20 which is defined by thin oxide layer 18 and like regions on the substrate are ion implanted. In a present embodiment a boron implant ($B_{11}$) at 75 KEV is employed to obtain a surface impurity level of 5-7 x $10^{12}/cm^2$; the thin oxide layer 18 is approximately 800 angstroms thick.

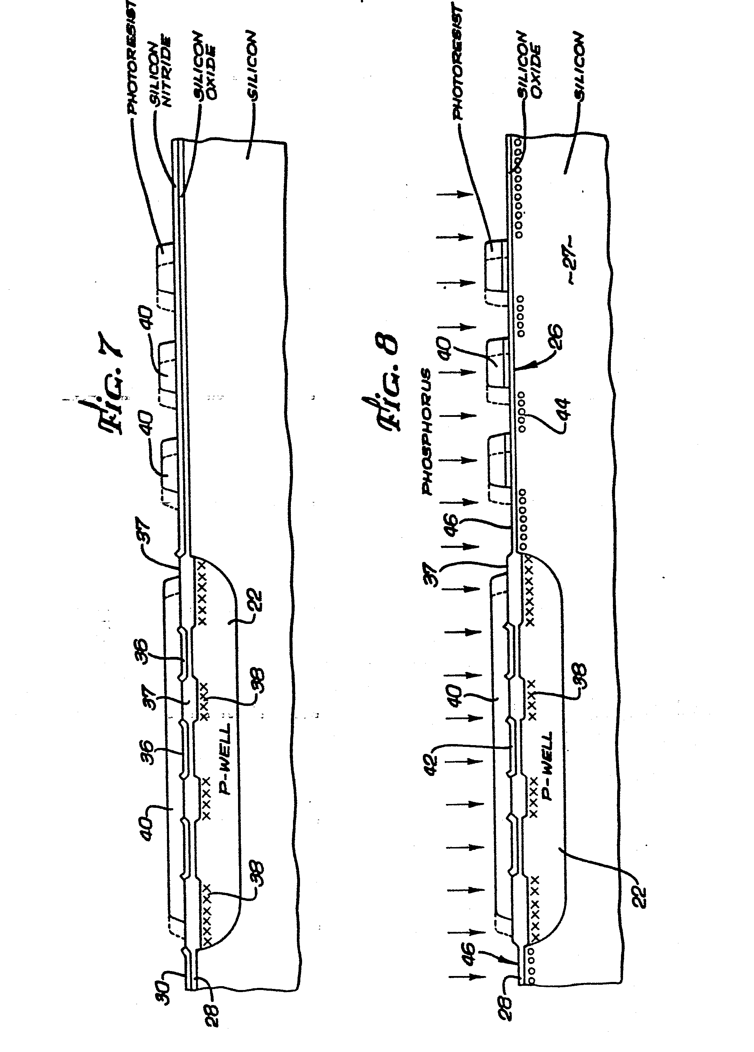

The substrate 10 is next subjected to a P-well diffusion (Step #5) to drive in the implanted boron thereby defining the P-well 22 as shown in Figure 3. During this P-well diffusion the thickness of the oxide layer 12 is increased. The parameters of this P-well diffusion are approximately 3 hours at approximately 1280° degrees centigrade in an oxidizing atmosphere which provides a P-well approximately 7 microns deep. Moreover, the P-well 22 from a functional standpoint must be sufficiently deep to avoid shorting of the source and drain regions of the N-channel device to the substrate 10. It should be noted that while one P-well is shown, it is consistent with the subject invention to form the integrated circuit utilizing a plurality of P-wells. The P-well forms one region in the substrate having the surface area 24 which region and area are for forming a first type of MOS device and specifically NMOS devices. The  other parts of substrate 10 not comprising a P-well form a second region 27 having surface area 26 wherein a second type of MOS device (e.g., PMOS) is formed.

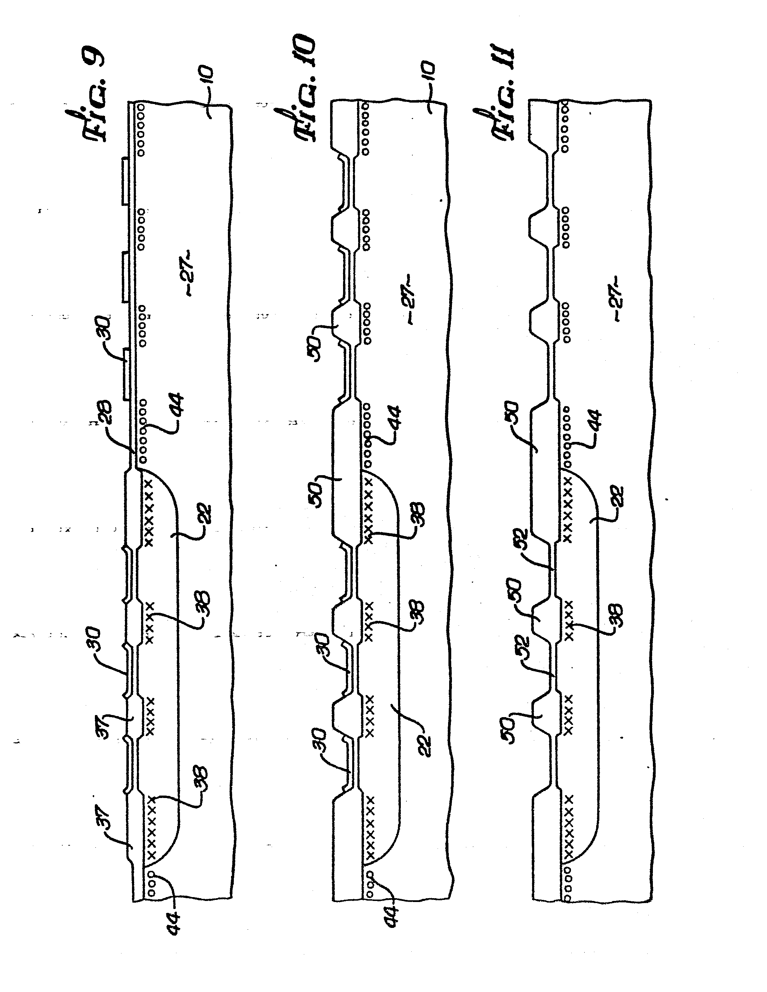

Following the formation of P-well 22 all oxide is removed (Step #6) and a thin layer of silicon oxide is formed on the surface of the substrate (e.g., approximately 1000 angstroms thick) and a thin layer of silicon nitride 30 is formed on the silicon oxide layer 28 (approximately 1000 angstroms thick) (Steps #7 and #8). The substrate 10 after formation of the silicon oxide and silicon nitride layers is shown in Figure 4. The silicon oxide layer 28 (i.e., $SiO_2$) may be formed by thermally growing the oxide layer on the surface of the substrate 10 after the oxide layer 12 has been removed. The silicon nitride layer 30 serves to mask the active device regions, that is the regions wherein the active devices will eventually be formed during the processing as field oxide is formed over the area of the substrate not covered by the patterned silicon nitride layer 30. In addition it has been found advantageous in the prior art to employ a layer of silicon oxide 28 between the oxidation masking material, that is silicon nitride layer 30, and the silicon substrate 10 to prevent the creation of defects in the substrate during subsequent thermal cycles and to provide a more desirable geometry to the isolation regions and field oxide. Further, in the present process silicon nitride layer 30 in combination with a photoresist material and the selective removal of portions of the silicon nitride layer 30 facilitates the forming of the self aligned NMOS field implant mask and the self aligned PMOS field implant mask. The specific individual steps associated with the forming of oxide isolation are adequately described in the general technical literature including the following publications: Semiconductor Silicon edited by Huff and Burgess, Princeton, New Jersey 1973, page 860 under the title "Selective Oxidation of Silicon and Its Device Application" by Kooi and Appels and "Local Oxidation of Silicon/CMOS Technology/Design System for LSI in CMOS", IEEE International Solid State Circuit Conference (Digest of Technical Papers) Session VLSI Logic 1974, page 60.

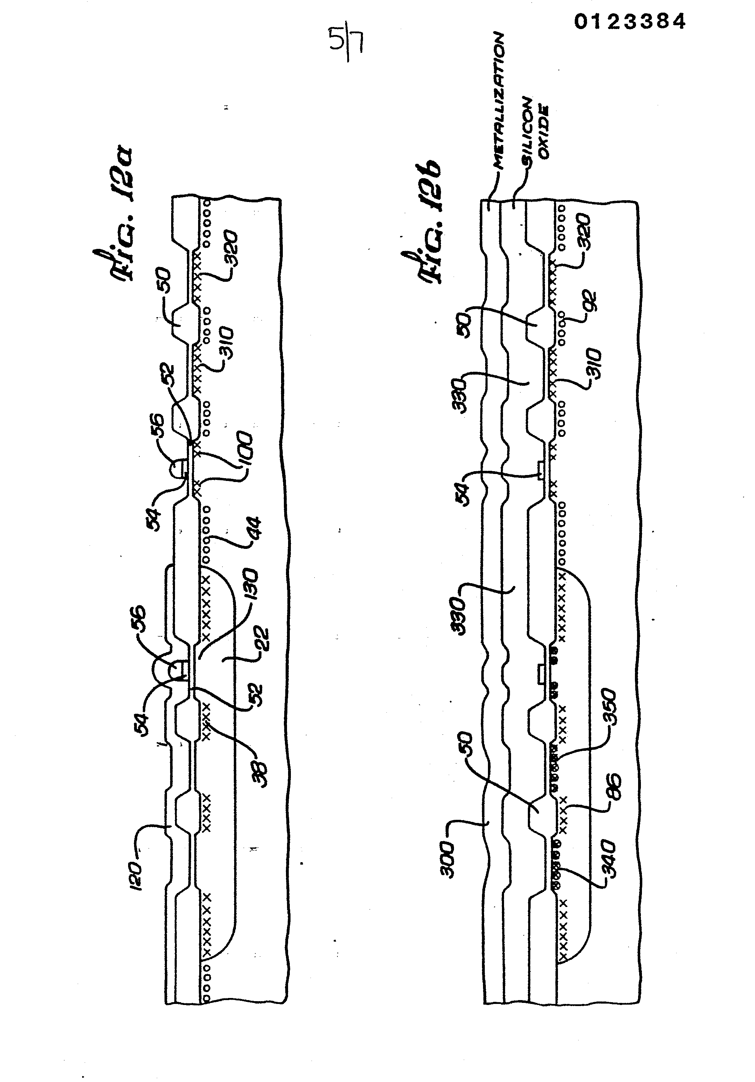

One important aspect of the invention is illustrated in Figures 5 through 9. These Figures show substrate 10 at various stages of its processing as the field associated with the first type of MOS device is implanted and then the field associated with the second type of MOS device is implanted so that both fields associated with the different types of MOS devices are separately and independently implanted and the field inversion voltage is independently altered accordingly. As indicated above, prior to this invention other means have been attempted to in effect accomplish a similar objective (e.g., U.S. Patents 4,013,484 and 4,027,380). In the present invention, split field masks are employed, that is, the field mask is split into two separate parts referred to as the N-field mask and the P-field mask. It is required that the split masking steps be performed prior to the field oxidation step is performed, that is, step 19 of the Summary Process Flow Chart. These split field masks are sequentially employed and as indicated on the Summary Process Flow Chart steps 9 through 18, each field mask step, that is the NMOS field mask step and PMOS field mask step, are followed by an intervening number of steps including a self aligned field implantation step in each case. It is these steps 9 through 18 of the Summary Flow Chart that summarize the major process steps regarding one important aspect of the subject invention. These process steps have been set out in the Summary Process Flow Chart in greater detail than other similar process steps because of the importance of these steps to the subject invention. The salient aspect of this part of the process is that there be one field mask processing step followed by a nitride etch and a self aligned field implant step followed by another field mask step followed by a self aligned field implant step with respect to such second nitride etch and second field mask step. It should be noted that all of the individual steps are consistent with present general practices in the art notwithstanding they provide the advantageous result of fields having specifically independently adjusted and altered inversion voltage levels associated with each of the two different types of MOS devices employed in CMOS integrated circuity. The use of photomasking materials (e.g., photoresist) to form the ion implant masks assists in achieving precise dimensional control and reducing yield losses as the thicknesses of nitride layer 30 and oxide layer 28 may be chosen to optimize dimensional control and yield without compromise.

Before proceeding with a more specific explanation of the steps 9 through 18 the N-field mask and P-field mask will be further defined. The N field mask, NF, is that portion of a conventional field mask which lies within P-well 22, PW. If F is a conventional field mask then NF = F·PW + ((PW + 4) inverse). The F·PW term is representative of the NMOS portion of F which lies within the P-well 22. The term ((PW + 4) inverse) is representative of the circuit regions which lie approximately 4 microns outside any P-well 22. The approximate 4 micron figure accounts for the lateral diffusion of the P-well as seen as region 5 in Figure 3. Similarly, the P-field mask, PF, is nearly the opposite of the N-field mask, NF. The P-field mask, PF, may be expressed as PF = F·(PW inverse) + (PW + 2). Once again, F·(PW inverse) represents the field pattern in the PMOS region, that is the region 26, 27 outside of P-well 22. The (PW + 2) term represents the region within the P-well which was patterned previously. The P-field mask extends approximately two rather than four microns beyond the P-well 22 and accounts in conjunction with the composite oxidation for misalignment. This assumes that a four micron spacing is applicable with respect to the lateral diffusion of the P-well. In the event of a different lateral diffusion as is anticipated the figures would change so that this should be regarded as a present example.

It should be understood in another embodiment of the invention, where a guard ring is formed, the foregoing masking relationship are altered. In such an embodiment the masking relationships are as follows: (1) NF = F·PW + (PW inverse); and (2) PF = F·(PW inverse) + (PW + 4). This change in masking relationships eliminates the need for the composite oxide and enables a guard ring to be formed. This will be further explained in connection with Figures 13-16. Notwithstanding the specific masking relationships are different in the guard ring and no guard ring embodiments, both embodiments employ the split field masking method enabling nitride etching and self aligned field implants employing photo material (e.g., resist) masks.

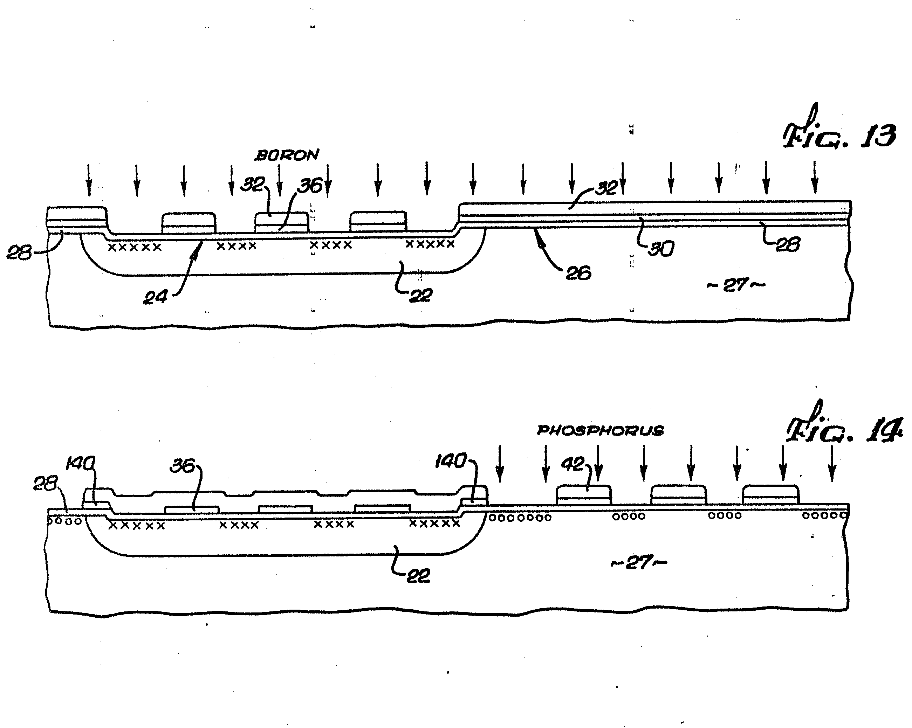

The specific process steps will now be described with reference to Figures 5 through 8 and the Summary Process Flow Chart steps 9 through 17. Referring to Figure 5 after the formation of silicon oxide layer 28 and silicon nitride layer 30, N-field mask 32 is formed on silicon nitride layer 30 (Step #9). The N-field mask 32 is formed by conventional photoresist masking techniques wherein a layer of photoresist is first formed on silicon nitride layer 30 and then exposed by contact, projection or direct step and repeat masking equipment to form a pattern of exposed and unexposed portions of said photoresist layer. The photoresist layer is then developed leaving a pattern of photoresist material 32 on silicon nitride layer 30 with the portions of silicon nitride layer that are to be removed exposed, such as portions 34. With portions of silicon nitride layer 30 exposed substrate 10 next has the exposed portions of the nitride layer 30 removed by a standard plasma nitride etch step (Step #10). The substrate as shown in Figure 6 illustrates the manner in which the nitride layer has been selectively removed by the nitride etch step. It should be noted that the nitride has been removed in areas defined above as the compliment of the N-field mask. These areas are substantially coincident with the area overlying the P-well with the exception that the nitride has been retained in areas where active NMOS devices are to be formed in the P-well. Such portions of the nitride layer that have been retained over a part of the P-well is indicated at nitride layer portions 36.

With the N-field mask so formed a self aligned NMOS or self aligned N-field ion implantation step is performed (Step #11). In the present process the self aligned N-field implant is a boron ($B_{11}$) implant at 75 KEV to obtain an impurity level of $4 \times 10^{13}/cm^2$ with oxide layer 28 having a thickness of 800 to 1000 angstroms. (The substrate after implantation is illustrated in Figure 6 wherein the X's 38 adjacent the surface 24 of P-well 22 are representative of the boron implant that is provided by the implantation step. While preferably the self aligned field implant is introduced by ion implantation because the dosage and energy of implantation can be carefully controlled, in this case, the impurity atoms enter the surface of the substrate and repose at a shallow depth. When driven into the substrate by subsequent processing steps, such a field implant raises the surface concentration of the P-type impurity in the P-well 22 and prevents inversion in the vicinity of the surface 24 of the P-well where the field oxidation layer will eventually be formed. Such inversion could occur between N-type diffusion regions which form parasitic N-channel devices. Typically, the impurity concentration of the field implant is about one order of magnitude greater than the remainder of the surface of the P-well.)

The photoresist layer 32 that remains in place over the patterned silicon nitride layer 30 protects the remainder of the substrate from being implanted by the ion implantation step and self aligns this implant to the etched silicon nitride pattern. After this implantation, the photoresist pattern is stripped and removed from the surface of substrate 10 and the remaining silicion nitride and silicon oxide layers are cleaned by conventional cleaning steps (Step #12).

The next process step to be performed is the N field drive-in and composite oxidation step (Steps #13 and 14). The N-field drive-in step is a conventional step to move the boron field implant 38 away from the silicon silicon oxide interface so that it will not overly deplete during the subsequent formation of the field oxide and isolation regions. The composite oxidation step results in composite silicon oxide layer 37 which is typically approximately 2000 angstrom thick and is formed by steam oxidation in the regions where the silicon nitride layer 30 was removed to enable the N-field implant and the silicon oxide layer 28 is exposed.

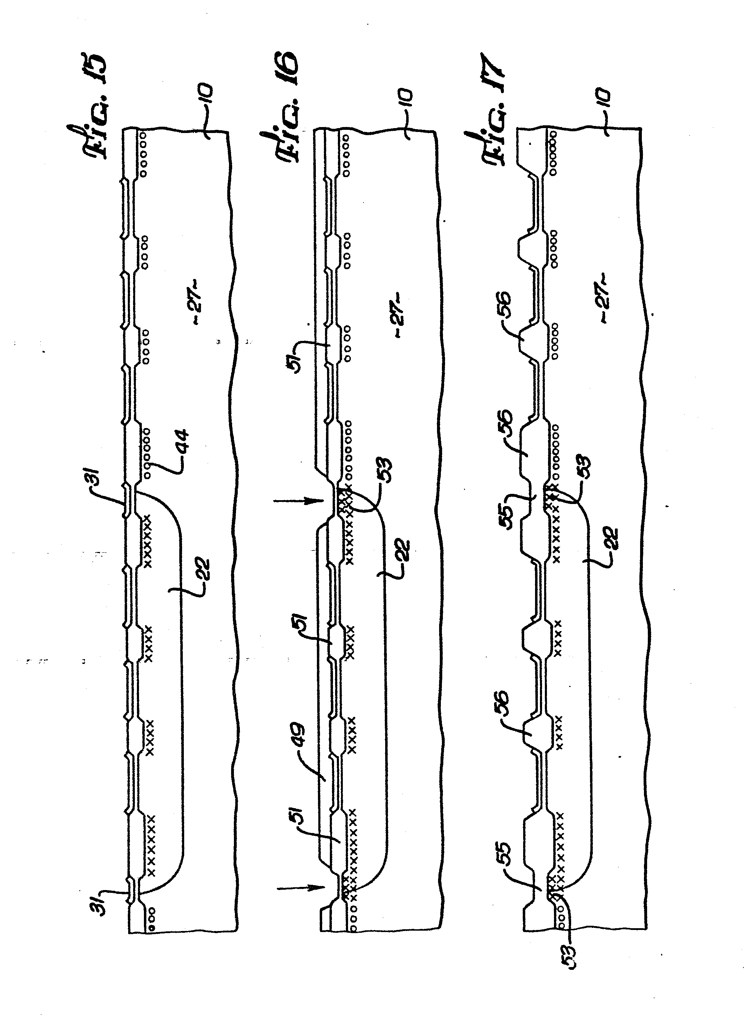

This composite oxide 37 is provided to subsequently self-align the two field implants at the perimeter of the P-well independent of mask alignment and tolerances. The composite oxide also insures that all the nitride can be removed where desired and in those regions where the nitride would have been etched twice there will be a thick oxide (e.g., 2000A) to protect the silicon surface which thereby avoids damaging the substrate being processed. Figure 7 shows substrate 10 after the formation of the composite oxide 37 and after forming the P-field mask 40. It can be seen from Figure 7 that a misalignment of the P-field mask will not result in damage to substrate 10 or failure to remove the silicon nitride at the perimeter of the P-well and assures that the two field implants are self aligned at the perimeter of the P-well. Later in this description it will become apparent how overlapping of the P-field mask around the perimeter of the P-well can facilitate the formation of a guard ring.

Following the N-field drive-in and composite oxidation, the PMOS or P-field mask and PMOS or P-field implant process steps are performed (Steps #15 to 18). These steps are generally substantially identical to the steps employed to the N-field mask step and N-field implant step with the exception such steps are performed with respect to the second region 26, 27 of substrate 10 that is the region where the PMOS devices are formed and in connection with the field associated with such devices and with the exception that the implant is of a N-type impurity such as phosphorous which does not require a separate drive-in cycle as it does not overly deplete from the silicon surface during the subsequent field oxidation. As shown in Figure 7, the P-field mask is formed by photoresist layer 40 which is patterned by the photolithographic techniques as described above. The desired pattern covers and protects the portions of nitride layer 30 that are to be retained on oxide layer 28 and exposes those portions of silicon nitride layer 30 that are to be removed. In addition, the patterned photoresist layer 40 covers the underlying portions of the patterned silicon nitride layer 30 that were previously exposed as a result of the prior N-field mask and N-field implant steps as indicated at 42. With the defined portions of silicon nitride layer 30 and silicon oxide layer at 42 protected from the effects of any etchant, the exposed portions of the silicon nitride layer 30 are removed (Step #16). The result of such nitride etch step is shown in Figure 8 where the exposed portions of silicon nitride layer 30 have been removed. It should be noted that the silicon nitride has now been removed from all portions of silicon oxide layer 28 where the field oxide and isolation regions will be subsequently formed. The silicon nitride pattern remain only on those areas of silicon oxide layer 28 overlying the regions of substrate 10 wherein active devices are to be formed.

With the P-field mask formed and the nitride etch complete an ion implantation is now performed to add an N-type impurity to those portions of the substrate 46 underlying exposed silicon oxide layer 28 (Step #17). The P-field mask along with the composite oxide 37 prevent the implantation from affecting those areas so covered. The N-type field implant is generally phosphorous, but it is possible to employ arsenic accomplished by an ion implantation. With a photoresist P-field mask thickness of approximately one micron and a silicon oxide layer thickness of approximately 800 to 1000 angstroms a phosphorous field ion implantation of $5 \times 10^{11}/cm^2$ can be accomplished at an energy of 120 KEV. The concentration of the field implant accomplished is typically approximately one order of magnitude higher than that which exists in the N-type substrate. This P-field implant independently increases the field inversion voltage associated with the field of the PMOS devices. Such inversion would occur between P-type diffusion regions which form parasitic P-channel devices. As shown in Figure 8 the areas where the P-field implant has occured are represented by a 0's 44 adjacent to the silicon substrate surface 46. As previously stated region 44 is self aligned by the composite oxide 37 to region 38 as the composite oxide masks the field implant 44 as does the photoresist layer 40. In Figures 7 and 8 the dashed outline for photoresist layer 40 shows this layer miss-aligned.

With the PMOS field implant completed the photoresist (i.e., P-field mask) is stripped from the substrate 10 and the substrate is cleaned according to standard techniques. (Step #18) The resulting substrate is as shown in Figure 9. In one embodiment of the subject invention the substrate 10 from this stage to completion is processed in accordance with standard isoplanar processes for forming MOS and CMOS integrated circuits. As previously mentioned, such techniques and processes are described in U.S. Patent 3,648,125, U.S. Patent 3,752,711, U.S. Patent 3,913,211, U.S. Patent 4,013,484 and U.S. Patent 4,027,380. The Summary Process Flow Chart from process steps 19 through 36 summarizes such a conventional isoplanar process which may be employed consistent with the subject invention. However, in one embodiment of the invention as will be explained later, the masking steps and the field oxidation step is altered to facilitate the inclusion of a guard ring. This change along with the change in the masking relationships heretofore mentioned are the primary process changes in the guard ring embodiment of the invention. In another aspect of the invention, the polysilicon photoresist mask is retained in position during the boron implant step (Step #32) to provide a gate or gate electrode free of boron. These specific process steps generally listed in the Summary Process Flow Chart will be more specifically discussed later in the specification.

Following completion of the formation of the field implants the field oxide regions 50 are formed as shown in Figure 10. (Step #19) These field oxide regions are formed wherever silicon nitride layers 30 are not present. The field oxide regions 50 typically may have a thickness of 1 micron. The field oxide regions 50 are formed over the portions of semiconductor substrate 10 that have been previously subject to a field implant and tend to drive the field implanted regions of substrate 10 deeper into the substrate.

Subsequent to the formation of field oxide region 50, nitride layers 30 and the silicon oxide underlying such silicon nitride is removed from the substrate and substrate 10 is cleaned in accordance with conventional techniques (Step #20). Thereafter, gate oxide material 52 which comprises part of the MOS devices to be formed in both first region 22 and second region 27 is formed as shown in Figure 11. The gate oxide material 52 is preferably silicon dioxide which is thermally grown to produce desirable interface characteristics with the underlying silicon substrate 10. Typically, gate oxide layer 52 when silicon dioxide has a thickness of 400 to 800 angstroms (Step #21).

As listed in the Summary Process Flow Chart, steps 22 through 27 comprise threshold adjust steps to precisely set the threshold voltage of underlying defined areas of gate oxide 52. In this regard, the defined areas for the threshold adjust steps should include those areas wherein the channels of the MOS devices are to be formed. The threshold adjust steps or one such step while not required are preferred to obtain an MOS device having certain desirable characteristics. The threshold adjust steps may be performed both with respect to defined areas of silicon substrate 10 underlying gate oxide 52 associated with the P-well 22 that is, the region wherein the N-MOS type devices are to be formed and silicon substrate 10 of region 27 underlying the gate oxide 52 wherein the the PMOS devices are to be formed. The N-threshold adjust steps are performed on P-well and the P-threshold adjust steps are performed with respect to region 27. Such adjust steps are well-known in the art and are described in detail in such patents as U.S. Patent 3,412,545 (Re 29,660) and U.S. Patent No. 4,053,229 (Intel) Pashley.

With the gate oxide 52 formed and the threshold adjust steps completed, the fabrication of the active devices, that is, the PMOS and NMOS devices, may be completed. As set forth in the Summary Process Flow Chart, the steps 28 through 37 result in the completion of the CMOS integrated circuit. To accomplish this, a layer of polysilicon is deposited over gate oxide 52. This layer of polysilicon is employed as part of the gate (commonly referred to as the gate electrode) and it also may be employed as an interconnect layer (Step #28). After the deposition of the polysilicon layer, an impurity preferably phosphorous is deposited thereover to render the polysilicon conductive as required (Step #29). Following the deposition of the phosphorous, a masking step is performed employing a photoresist material (Step #30). It should be understood that the masking step may be preceded by or may include a clean and oxide strip step and a phorsphorous reoxidation step. This masking step employs conventional photo lithographic steps as hereinbefore described and results in defining the polysilicon gate electrode and interconnects.

At this point it should be noted that one aspect of the present invention is to retain the photoresist layer of the polysilicon mask in place as a protective coating for the silicon gate electrode during a subsequent processing step wherein the substrate is exposed to a boron ion implantation. Such boron ion implantation occurs in the formation of the source and drain regions associated with the PMOS devices to be formed in the region 27 of substrate 10. This retention of the photoresist layer is illustrated in Figure 12a wherein substrate 10 is shown after polysilicon layer 54 has been defined on the gate oxide 52 with the photoresist layer 56 overlying such polysilicon layer 54. It should be noted that after the pattern of photoresist is formed on the polysilicon the polysilicon is etched preferably in a $CF_4 + O_2 + H_e$ plasma. In Figure 12a, the substrate 10 is shown just prior to the boron implant step (Step #32) and after the PMOS source/drain implantation masking step 120 wherein the gate oxide 52 overlying the area of region 100 where the source and drain region of the PMOS devices are to be formed is uncovered. The boron implant is effectuated through said gate oxide 52. Notwithstanding that the source and drain of the PMOS devices are to be formed by a boron implant photoresist layer 56 will protect the polysilicon gate 54 so that it is maintained free of boron. It has been found that the presence of boron in polysilicon gate 54 may lead to certain device instabilities especially if the gate oxide layer is made especially thin as is desirable.

In one embodiment of the subject invention gate electrodes 54 for all of the devices, that is both the NMOS devices and PMOS devices are simultaneously formed. Thereafter, the gate oxide associated with one of the types of devices (PMOS) to be formed is exposed. It is desirable if not required to protect the GATE OXIDE (or substrate surface) where the source and drain region of one of the devices is to be formed while the source and drain region of the other device is being formed. This can be accomplished by a number of different process steps. For example, a photoresist mask or other suitable mask can be superimposed over the source and drain regions with respect to one of the types of devices while the source and drain regions with respect to the other type of device are being formed via the gate oxide. In the embodiment of the invention set forth in the Summary Process Flow Chart, and in part illustrated in Figure 12, the gate oxide overlying the areas where the source and drain region of the PMOS device are to be formed is exposed. The gate oxide 52 overlying the surface area of substrate 10 wherein the source and drain region are to be formed with respect to the NMOS devices 130 of P-well 22 is protected by a photoresist mask 120 superimposed over gate electrode 54, photoresist 56 and gate oxide layer 52. This photoresist mask protects the source and drain regions of the NMOS devices 130 from being affected by the formation of the source and drain regions of the PMOS devices. The source and drain regions of the PMOS devices may then be formed by a boron implant step (Step #32) such step being performed in accordance with well-known techniques as hereinbefore referred to. It should be noted that during this boron implant gate electrode 54 is protected from the boron as is the gate and gate oxide associated with the NMOS devices to be formed in P-well 22.

In one embodiment of the subject invention the NMOS devices are next completed by the proceeding with an NMOS diffusion mask step wherein the gate oxide and other masking material overlying such gate oxide is removed to expose the surface of substrate 10 where the source and drain regions are to be formed with respect to the NMOS devices in P-well 22 (Step #34). This is followed by a phosphorous thermal deposition and diffusion step to form source and drain regions of the NMOS devices of P-well 22 (Step #35).

As indicated on the Summary Flow Process Chart, the CMOS integrated circuit is completed by conventional deposition of an oxide layer to isolate the polysilicon electrode from the aluminum electrode, then forming of the contact openings and interconnects by such process steps as a Silox deposition, Silox flow, contact opening masking, silox reflow, metal deposition, metal interconnection masking and alloying. Following the formation of such contacts and interconnects the device is protected by a scratch protection oxide deposition followed by scratch protection oxide masking. Figure 12(b) illustrates the substrate after the formation of the metal interconnect layer 300. The PMOS parasitic transistor is comprised of a source diffusion 310, a drain diffusion 320, a gate oxide comprised of the combined isolation oxide 330 and the field oxide 50 and a gate electrode comprised by the metal interconnect layer 300. The channel region of this PMOS parasitic transistor is that region 92 of the substrate which has been field implanted to increase the inversion voltage of this PMOS parasitic transistor substantially above the power supply voltage. In a similar manner the NMOS parasitic transistor is comprised of a source diffusion 340, a drain diffusion 350, a gate oxide comprised of the combined isolation oxide 330 and the field oxide 50 and a gate electrode comprised by the metal interconnect layer 300. The channel region of this NMOS parasitic transistor is that region 86 of the substrate which has been field implated to increase the inversion voltage of this NMOS parasitic transistor substantially above the power supply voltage.

It should be appreciated that the above process steps can be performed by various alternative steps and by various arrangements of the steps. The particular arrangement of the steps are not significant except to the extent they affect the attainment of a particular objective of the invention. It is of course understood that no one objective is essential and if any one of the objectives is obtained the overall and broad objective of the invention would be met.

As to the foregoing embodiment of the invention the most important individual and separable aspects of the invention are the providing of independent self aligned field implants for the field associated with both the PMOS devices and the NMOS devices which self aligned field implants are separately and independently formed and subject to separately being controlled and fixed, and the obtaining of a boron-free gate. With respect to the field implant aspects of the invention it has been found that the field inversion voltage achievable can be individually set over a wide range of useful values (25 volts to 60 volts or more) by merely increasing the field implant doses. As the ion implantation dose is increased over this range of doses the conventional breakdown voltage (BVDSS) within either the PMOS or NMOS regions does not necessarily immediately decrease but rather the gate oxide thickness (such as 500 angstroms) controls the breakdown voltage (BVDSS). Further it has been found that these results can reliably be achieved without lowering yields by employing split field photo material (e.g., resist) type masks.

One alternate embodiment of the invention involves forming a guard ring. As defined herein the guard ring surrounds the P-well. To form the guard ring the masking relationships are changed as heretofore described and the field oxidation step 19 is replaced with the following process steps:

19(a) First field oxidation.

19(b) Guard ring mask.

19(c) Guard ring nitride etch.

19(d) Guard ring implant.

19(e) Second field oxidation.

The adding of these additional steps and the mask changes enables a guard ring to be formed around the P-well 22. Figures 13, 14 15, 16 and 17 illustrate the substrate in various stages of these alternate process steps.

Figures 13, 14 and 15 show substrate in stages of processing comparable to the stages of processing shown in Figures 6, 7 and 9 respectively. From these Figures it can be seen that the N-field mask 32 (Fig. 13) and P-field mask 42 (Fig. 14) have been extended over nitride layer 30 so as to be in an overlapping relationship with respect to a portion of such layer 140. This results in nitride guard ring mask 31 (Fig. 15) being formed. The nitride oxidation mask 31 enables the guard ring to be formed later in the processing and also eliminates the need for the composite oxidation. The overlapping mask relationship required to form the nitride oxidation mask 31 results in any misalignment changing the absolute size of the oxidation nitride mask 31 in the guard ring region but in any event the substrate 10 and thin silicon oxide layer 28 remain protected during the removal of the other portions of nitride layer 30.

Figures 16 and 17 show the substrate 10 after the first field oxidation (Step 19(a)) with the guard ring resist mask 49 formed (Step 19(b)) and after the second field oxidation. Figure 17 is comparable to the processing stage shown in Figure 11 without a guard ring. To enable the formation of a guard ring covered by a relatively thick field oxide layer the substrate 10 of Figure 15 has the field oxide formed thereon in two separate steps. First as shown in Figure 16, a first field oxide layer 51 is formed having a typical thickness of approximately 6000°A. The field oxide is formed over all surface regions not covered by a nitride layer. The guard ring photoresist mask 49 is then formed exposing only the silicon nitride mask layer 31 (and some field oxide in proximity thereto). The silicon nitride mask layer 31 is then removed and a boron implant is performed resulting in the P+ guard ring 53. With the photoresist mask 49 removed the second field oxidation 56 is performed increasing the thickness of the first formed field oxide and forming a second field oxide 55 over the guard ring 53. As finally formed the field oxide 56 and field oxide over the guard ring 55 have typical thicknesses of approximately 10,000°A and 8200°A respectively.

Specifically, the steps 19(a) through 19(d) of the alternative process flow chart can be performed in the following manner:

Step #19(a) - first field oxidation, for 5 hours at
950°C

Step #19(b) - conventional GR mask = (PW-2) +
((PW+6) inverse),

Step #19(c) - standard guard ring nitride etch
operations,

Step #19(d) - 1.0 x $10^{15}$ boron implant at 75 KEV

Step #19(e) - second field oxidation, for 11 hours at
950°C.

The formation of this guard ring provides the advantage of reducing leakage currents at the perimeter of the P-well, providing a superior contact to the P-well and restraining the onset of "latch up. While such guard rings have been formed in prior art devices and while polysilicon cross-overs have been formed in such prior art it has not been practical to form a guard ring with a polysilicon cross-over passing over the guard ring. In accordance with the present invention this has been made practical because of the thick oxide over the guard ring which was formed in the second portion of the two step field oxidation.

In summary, a process has been disclosed which permits the fabrication of high-density, relatively high-voltage MOS devices which devices can be produced reliably and with relatively high yields. Furthermore, this process has particular advantages with respect to the fabrication of CMOS devices. And finally, a CMOS device is provided that has particular advantages and obtains superior results in comparison with other prior art devices. For example, because device characteristics are determined spearately and independently CMOS integrated circuits can be formed having devices with improved overall characteristics such as high field inversion voltage, high saturation current, an improved body constant and improved threshold voltages. The improved field inversion voltage is achieved without compromisingother device characteristics and without introducing process control and yield problems.

0123384

CLAIMS

1. On a silicon substrate which includes a first region for a first type of MOS device and a second separate region for a second type of MOS device, a process for independently setting the field inversion voltage of the field associated with the first type MOS device, and the field associated with the second MOS type device, comprising the steps of:

(a) forming a first photomaterial mask on said substrate that enables the field associated with said first type of MOS devices to be implanted with the same conductivity type as the conductivity type of the region wherein said first type of MOS device is to be formed;

(b) implanting the portion of said first region that is enabled for implantation with an impurity of the same conductivity type as said first region;

(c) forming a second photomaterial mask on said substrate that enables the field associated with said second type of MOS device to be implanted with the same conductivity type as the conductivity type of the second region wherein said second type of MOS device is to be formed; and

(d) implanting the portion of said second region that is enable for implanation with an impurity of the same conductivity type as the conductivity type of the second region whereby the fields associated with both said first type of MOS device and said second type of MOS device are implanted and their respective field inversion voltages are separately and independently determined.

2.  The process defined in Claim 1 wherein the first mask is defined by the relationship

NF = F·PW + ((PW+X) inverse); and the second mask is defined by the relationship

PF = F·(PW inverse) + (PW+Y), where X and Y are numerical values dependent on process design rules.

3.  The process defined by Claim 1 or 2 wherein the step of forming first mask includes the steps of (a) forming a layer of silicon oxide on said substrate; (b) depositing a layer of silicon nitride on top of said layer of silicon oxide; (c) forming said pattern of photomaterial on top of said silicon nitride, which pattern exposes the area of the silicon nitride overlying the area of the substrate which forms the field for the first type of MOS device; and (d) removing the exposed silicon nitride to expose the underlying silicon oxide which is in overlying self aligned relationship with respect to the field associated with the first type MOS device so that such field may be independently implanted with implant self aligned to the silicon nitride pattern.

4.  The process defined in Claim 1, 2 or 3 wherein a silicon oxide layer is formed after the implanting of the field associated with the first type MOS device, said silicon oxide layer being formed where said silicon nitride was removed to form a composite silicon oxide layer with said exposed silicon oxide layer.

5. The process defined in Claim $\not{2}$ *1,2,3 or 4* wherein the step of forming said second mask includes the steps of:

(a) forming a pattern of photoresist in part on the silicon nitride and in part on the silicon oxide, which silicon oxide was exposed during the formation of the first mask, said pattern of photoresist covering the surface of the first region that has been implanted and covering the silicon nitride overlying the second region wherein the second type of MOS device is to be formed; and

(b) removing the silicon nitride overlying the field forming part of the second area and which is not covered by photoresist.

6. The process defined in Claim 1 *any of to 5* wherein prior to the forming of the first mask a well region is formed in said substrate and comprises said first region for forming said first type of MOS device.

7. The process defined in Claim 1 *any of to 6* wherein after the implanting of the second region the following steps are performed; fabricating active devices in said substrate in said first and second regions.

0123384

33.

8. An isoplanar silicon gate CMOS intergrated circuit comprising:

(a) a monocrystalline silicon substrate including a first region having a first type of MOS device formed therein and a second and separate region having a second type of MOS device formed therein;

(b) said first region having a field associated with said first type of MOS device, which field is implanted with its threshold voltage independently determined; and

(c) said second region having a field associated with said second type of MOS device, which field is implanted with its threshold voltage independently and separately determined.

9. The CMOS integrated circuit defined in Claim 8 wherein said substrate includes silicon gate MOS devices having gate electrodes free of boron.

10. The CMOS integrated circuit defined in Claim 8 or 9 wherein a guard ring is formed in said substrate having the same conductivity type as said first region and surrounding said first region and wherein polysilicon crossovers are formed as part of such integrated circuit structure, which crossovers insulatively pass over said guard ring.

11. The integrated circuit defined by Claim 8, 9 or 10 wherein said first region has a guard ring surrounding said region.

12. The integrated circuit defined in Claim 9, 10 or 11 wherein a thick oxide layer separates the crossovers from said guard ring.

13. The integrated circuit defined in Claim 12 wherein said oxide layer is in excess of approximately 5000 angstroms.

14. On a silicon substrate which includes a first region for forming a first type of MOS device and a second separate region for forming a second type of MOS device, a process for forming a guard ring around said first region and for forming a field isolation oxide between said first and second regions, said process comprising the steps of,

(a) forming an oxidation inhibiting mask on a portion of the surface of said substrate which mask includes portions overlying at least a part of said first region and said second region and a portion overlying the region where said guard ring is to be formed;

(b) forming a first oxide isolation layer over portions of said substrate wherein an oxidation mask is not present;

(c) removing the oxidation mask overlying the regions where said guard ring is to be formed;

(d) forming said guard ring by introducing impurities into the portions of the substrate wherein said oxidation mask has been removed;

(e) and forming a second oxide isolation field layer over said guard ring and said first oxide isolation layer.

FIG. 1

PHOTORESIST

SILICON OXIDE (SiO₂)

SILICON

FIG. 2

BORON IMPLANT

SILICON OXIDE (SiO₂)

SILICON

FIG. 3

SILICON OXIDE (SiO₂

P-WELL

SILICON

**FIG. 4**

SILICON NITRIDE
SILICON OXIDE
SILICON

P - WELL

N

~27~

24  30  28  26  22

**FIG. 5**

PHOTORESIST
SILICON NITRIDE
SILICON OXIDE
SILICON

P - WELL

~27~

32  34  32  34  32  32  30  28  26  22  24

**FIG. 6**

BORON

PHOTORESIST
SILICON NITRIDE
SILICON OXIDE
SILICON

P - WELL

~27~

32  32  32  36  36  32  30  28  26  38  24  22  38

0123384

Fig. 7

PHOTORESIST
SILICON NITRIDE
SILICON OXIDE
SILICON

Fig. 8

PHOTORESIST
SILICON OXIDE
SILICON

PHOSPHORUS

4/7

**FIG. 9**

37   37   30   28   30

44

38   38   22   44   ~27~   10

**FIG. 10**

30   30   50   50

44   22   38   38   44   ~27~   10

**FIG. 11**

50   52   50   52   50

44   38   22   44   ~27~

FIG. 12a

FIG. 12b

METALLIZATION

SILICON OXIDE

5/7

0123384

BORON

FIG. 13

PHOSPHORUS

FIG. 14

Fig. 15

31                  31

44

22         ~27~        10

Fig. 16

51    49    51      51

53

22      ~27~      10

Fig. 17

55    56    55    56    56

53           53

22      ~27~      10

0123384

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | DE-A-2 700 873  (HITACHI)<br>* Claim 1; pages 11-13, 15 * | 1,3-8 | H 01 L  21/82<br>H 01 L  27/08 |
| A | US-A-4 325 169  (PONDER et al.)<br>* Claims 1, 2; column 2, lines 9-60; figures 1-10 * | 1,3-7 | |
| A | US-A-4 244 752  (HENDERSON et al.)<br>* Claims 1, 5, 7, 8; column 3, line 11 - column 4, line 58 * | 1,3-7 | |
| A | FR-A-2 447 095  (SGS-ATES)<br>* Claims 1, 2; page 4, line 14 - page 6, line 15; figures 1-6 * | 10,11, 14 | **TECHNICAL FIELDS SEARCHED (Int. Cl. ³)** |
| A | DE-A-2 740 549  (SANYO)<br>* Claims 1-14; page 10, lines 10-30 * | 1,8 | H 01 L  21/00<br>H 01 L  27/08 |
| A | DE-A-2 523 379  (FAIRCHILD)<br>* Pages 3, 4 * | 9 | |

The present search report has been drawn up for all claims

| Place of search<br>BERLIN | Date of completion of the search<br>17-05-1984 | Examiner<br>ROTHER A H J |
|---|---|---|